# EUROPEAN PATENT SPECIFICATION

(11) **EP 1 127 407 B1**
(45) Date of publication and mention of the grant of the patent: **21.07.2010**
(21) Application number: 00964063.2
(22) Date of filing: 30.08.2000
(51) Int. Cl.: H03F 1/30

(54) **AN AMPLIFIER FOR USE IN A MOBILE PHONE**
VERSTÄRKER ZUR VERWENDUNG IN EINEM MOBILTELEFON
AMPLIFICATEUR DESTINE A UN TELEPHONE MOBILE

(30) Priority: 08.09.1999 EP 99202921
(43) Date of publication of application: 29.08.2001
(73) Proprietor: NXP B.V., 5656 AG Eindhoven (NL)
(72) Inventor: PRIKHODKO, Dimitri, P., NL-5656 AA Eindhoven (NL); CAIRO MOLINS, Josep, I., NL-5656 AA Eindhoven (NL); VISSER, Hendrik, A., NL-5656 AA Eindhoven (NL)
(74) Representative: Schouten, Marcus Maria
(86) International application number: PCT/EP2000/008452
(87) International publication number: WO 2001/018958

(56) References cited:
- EP-A- 0 425 035
- US-A- 5 343 141
- WOERD VAN DER A C ET AL: "IEEE JOURNAL OF SOLID-STATE CIRCUITS,US,IEEE INC. NEW YORK" IEEE JOURNAL OF SOLID-STATE CIRCUITS,US,IEEE INC. NEW YORK, vol. 28, no. 10, 1 October 1993 (1993-10-01), pages 1052-1055, XP000400101 ISSN: 0018-9200

## Description

The invention relates to an amplifier for supplying a signal to a load, comprising a first transistor having a first main terminal coupled to a reference terminal, a control terminal, and a second main terminal for supplying the signal to the load, and sensing means for determining the value of the signal.

Such an amplifier is known from the US patent 5,285,143.

In the known amplifier, a sense current is generated from a load current which is scaled down such that the sense current is an accurate representation of the load current but has a substantially smaller magnitude. The scaled down sense current is generated by coupling a power sense resistor in series with the load current and develops a load voltage across this resistor. A sense voltage, being substantially equal to the load voltage, is applied to a pilot sense resistor by a voltage follower. The pilot sense resistor is some predetermined ratio of the power sense resistor. The sense current flowing through the pilot sense resistor is scaled down in accordance with the ratio of the power resistor to the pilot sense resistor. A current mirror supplies current to the voltage follower.

A problem of the known amplifier is that a sensing element, for example formed by a resistor, is coupled in series with the first transistor. Though a high accuracy of the sense signal (current) can be accomplished in this manner in principle, the circuitry needed in order to reach this accuracy is quite complicated.

Document "Low-Voltage Low-Power Controllable Preamplifier for Electret Microphones" of A.C. van der Woerd and W.A. Serdijn, IEEE JOURNAL OF SOLID-STATE CIRCUITS, US, IEEE INC. NJ, vol. 28, nr. 10, pages 1052-1055, discloses a low-voltage low-power analog controllable preamplifier for electret microphones, wherein the gain of the amplifier is controlled by means of a dc current for offset feedback by feed-back of a copy of the output current via a low-pass filter.

EP 0 425 035 discloses an overload protection drive circuit for a power transistor comprising a sensing transistor for providing a drain source bypass for the power transistor. The bypass is formed by a first resistor in series with the drain and a second resistor in series with the source. The voltage developed across one of the resistors is arranged to trigger a switching circuit to inhibit drive upon occurrence of a predetermined voltage to prevent excessive drain source current. However, due to the nature of the application, the protection drive circuit is configured to evaluate a sensing current corresponding to the absolute current flowing through the power transistor for triggering the switching circuit.

US-A-5 343 141 discloses a transistor overcurrent protection circuit using an error amplifier to make a voltage comparison between a threshold voltage and the collector voltage of a current sensing transistor. The current sensing transistor is arranged in a circuit such that the collector current of the current sensing transistor is a measure of the collector current of an output transistor. A driver transistor has its emitter connected to the base of the output transistor. A source of control current to the drive transistor is coupled to the output of the error amplifier. When the collector voltage of the current sense transistor falls below the threshold voltage, the error amplifier causes the control current to the drive transistor to be reduced so as to reduce the collector current of the output transistor.

It is an object of the invention to provide an amplifier which eliminates the above-mentioned problem.

The object is achieved by means of a amplifier as defined in claim 1. Further embodiments are defined in claims 2 to 6. A particular application of the amplifier according to the invention is defined in claim 7.

To this end, according to the invention, the amplifier of the type defined in the opening paragraph is **characterized in that** the sensing means comprises a second transistor having a first main terminal coupled to the first main terminal of the first transistor, a control terminal coupled to the control terminal of the first transistor, and a second main terminal for supplying a further signal which is a representation of the signal, and in that the amplifier comprises detection means for supplying a DC-component of the further signal.

The invention is based on the insight that for many applications, and especially for mobile phones, amplifiers do not operate in the so called class A mode in which the power consumption is relatively high, but operate in a lower-energy mode, for example in the so called class B or class C mode. In these modes the signal comprises a DC component which is proportional to the signal and is thus also proportional to the power supplied to the load. Since the further signal is a representation of the signal supplied to the load, the further signal also comprises a DC-component which is a measure for the power supplied to the load. This measure can be used to monitor the amount of power supplied to the load and possibly to regulate the power to a desired level.

An embodiment of the invention may be **characterized in that** the detection means comprises a resistor coupled between a power supply terminal and the second main terminal of the second transistor, and a capacitor coupled between the second main terminal of the second transistor and the reference terminal. By so doing, a simple implementation of the detection means is accomplished. As an alternative solution the capacitor may also be connected between the second main terminal of the second transistor and the power supply terminal.

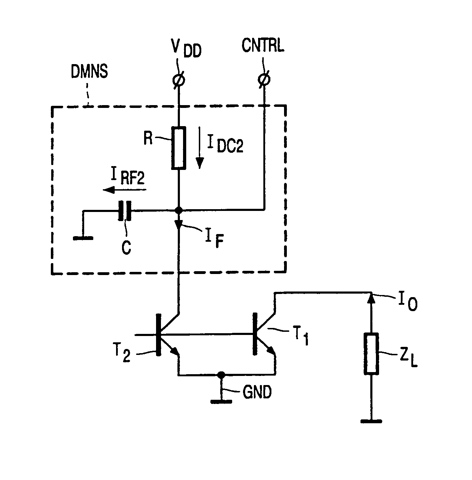

The invention will be described in more detail with reference to the accompanying drawing, in which:
the sole Figure is a circuit diagram of an embodiment of an amplifier according to the invention.

The Figure shows a circuit diagram of part of the amplifier which comprises a first bipolar transistor T₁, a second bipolar transistor T₂, and detection means DMNS formed by a resistor R and a capacitor C. A load Z_{L} is connected between the collector of the first bipolar transistor T₁ and a reference terminal GND. The emitters of the first and the second bipolar transistors T₁ - T₂ are connected to the reference terminal GND. The collector of the second bipolar transistor T₂ is connected to a control terminal CNTRL. The resistor R is connected between a power supply terminal V_{DD} and the control terminal CNTRL. The capacitor C is connected between the control terminal CNTRL and the reference terminal GND.

The principle of operation of the circuit is as follows. The first and second bipolar transistors T₁ and T₂ are dimensioned such that the further signal current IF, which flows through the first bipolar transistor T₁, is a fraction of the signal current Iₒ, which signal current Iₒ flows through the first bipolar transistor T₁ and through the load Z_{L}. If the first and second bipolar transistors T₁ and T₂ are matched in a proper way, for instance by integrating both the first and the second bipolar transistors T₁ - T₂ in the same integrated circuit, the further signal current IF is an accurate, but much smaller, copy of the signal current Iₒ. Under the assumption that the amplifier is, for example, operating in the so-called class C mode, the signal Iₒ comprises a DC-component which is a measure for the signal Iₒ and as a consequence it is also a measure for the amount of power supplied to the load Z_{L}. Since the further signal IF accurately matches the signal Iₒ, the further signal IF also comprises a DC-component I_{DC2} which accurately matches the DC-component of the signal Iₒ. Thus the DC-component I_{DC2} is an accurate representation of the amount of power supplied to the load Z_{L}. The capacitor C forms a short-circuit for AC-currents. For this reason only the DC-component I_{DC2} flows through the resistor R, causing a DC-voltage across the resistor R. This DC-voltage is made available via a control terminal CNTRL. Since this DC-voltage is an accurate measure for the power supplied to the load Z_{L}, this DC-voltage can be used to monitor the amount of power supplied to the load Z_{L} and possibly to regulate the power to a desired level.

Instead of bipolar transistors, other active amplifier elements, such as field effect transistors, may alternatively be used.

## Claims

1. An amplifier for supplying a signal (Io) to a load (ZL), comprising:
- a first transistor (T1) having a first main terminal connected to a reference terminal (GND), a control terminal, and a second main terminal for supplying the signal (Io) to the load (ZL),
- sensing means for determining the value of the signal (Io), wherein the sensing means comprises a second transistor (T2) having a first main terminal connected to the first main terminal of the first transistor (T1), a control terminal coupled to the control terminal of the first transistor (T1), and a second main terminal for supplying a further signal (IF), which is a representation of the signal (Io), and
- detection means (DMNS) for supplying a DC-component of the further signal (IF), wherein the further signal is a representation of the signal (Io) and the DC-component of the further signal (IF) is provided as a measure for the power supplied by the signal (Io) to the load (ZL).

2. An amplifier as claimed in claim 1, wherein the detection means (DMNS) comprises a resistor (R) connected between a power supply terminal (VDD) and the second main terminal of the second transistor (T2), and a capacitor (C) connected to the second main terminal of the second transistor (T2), and
wherein the capacitor (C) is configured to form a short-circuit for AC-currents such that only the DC-component of the further signal (IF) flows through the resistor (R), and the DC-component of the further signal (IF) is provided as a measure for the power supplied by the signal (Io) to the load (ZL) via a control terminal (CNTRL) connected to the second main terminal of the second transistor (T2).

3. An amplifier as claimed in claim 2, wherein the capacitor (C) is connected between the second main terminal of the second transistor (T2) and the reference terminal (GND).

4. An amplifier as claimed in claim 2, wherein the capacitor (C) is connected between the second main terminal of the second transistor (T2) and the power supply terminal (VDD).

5. An amplifier as claimed in one of the preceding claims, wherein the first and second transistors (T1, T2) are dimensioned such that the further signal (IF), which flows through the first transistor (T1), is a fraction of the signal (Io), which flows through the first transistor (T1), and through the load (ZL).

6. An amplifier as claimed in one of the preceding claims 2 to 5, wherein the DC-component of the further signal (IF) as a measure for the signal (Io) is provided via a control terminal (CNTRL) as a DC voltage across the resistor (R).

7. A mobile phone comprising a transmitter having an antenna for transmitting a modulated high-frequency signal, comprising an amplifier of the type as claimed in one of the claims 1 to 4, wherein the load (ZL) is formed by the antenna.

## Patentansprüche

1. Verstärker zum Zuführen eines Signals (Io) zu einer Last (ZL), umfassend:
einen ersten Transistor (T1), der einen ersten Hauptanschluss, der mit einem Referenzanschluss (GND) verbunden ist, einen Steueranschluss und einen zweiten Hauptanschluss zum Zuführen des Signals (Io) zu der Last (ZL) aufweist,
Abtastmittel zum Bestimmen des Wertes des Signals (Io), wobei das Abtastmittel einen zweiten Transistor (T2) umfasst, der einen mit dem ersten Hauptanschluss des ersten Transistors (T1) verbundenen ersten Hauptanschluss, einen mit dem Steueranschluss des ersten Transistors (T1) gekoppelten Steueranschluss und einen zweiten Hauptanschluss zum Zuführen eines weiteren Signals (IF), welches eine Repräsentation des Signals (Io) ist, aufweist, und
Bestimmungsmittel (DMNS) zum Zuführen einer Gleichstromkomponente des weiteren Signals (IF), wobei das weitere Signal eine Repräsentation des Signals (Io) ist und die Gleichstromkomponente des weiteren Signals (IF) als ein Maß für die durch das Signal (Io) der Last (ZL) zugeführte Leistung bereitgestellt wird.

2. Verstärker nach Anspruch 1, wobei das Bestimmungsmittel (DMNS) einen Widerstand (R), der zwischen einem Stromzuführungsanschluss (VDD) und dem zweiten Hauptanschluss des zweiten Transistors (T2) angeschlossen ist, und einen mit dem zweiten Hauptanschluss des zweiten Transistors (T2) verbundenen Kondensator (C) umfasst, und
wobei der Kondensator (C) so ausgeführt ist, dass er einen Kurzschluss für Wechselströme bildet, so dass nur die Gleichstromkomponente des weiteren Signals (IF) durch den Widerstand (R) fließt, wobei die Gleichstromkomponente des weiteren Signals (IF) als ein Maß für die durch das Signal (Io) der Last (ZL) über einen mit dem zweiten Hauptanschluss des zweiten Transistors (T2) verbundenen Steueranschluss (CNTRL) zugeführte Leistung bereitgestellt wird.

3. Verstärker nach Anspruch 2, wobei der Kondensator (C) zwischen dem zweiten Hauptanschluss des zweiten Transistors (T2) und dem Referenzanschluss (GND) angeschlossen ist.

4. Verstärker nach Anspruch 2, wobei der Kondensator (C) zwischen dem zweiten Hauptanschluss des zweiten Transistors (T2) und dem Stromversorgungsanschluss (VDD) angeschlossen ist.

5. Verstärker nach irgendeinem der vorangehenden Ansprüche, wobei die ersten und zweiten Transistoren (T1, T2) so dimensioniert sind, dass das weitere Signal (IF), das durch den ersten Transistor (T1) fließt, ein Bruchteil des Signals (Io) ist, das durch den ersten Transistor (T1) und die Last (ZL) fließt.

6. Verstärker nach irgendeinem der vorangehenden Ansprüche 2 bis 5, wobei die Gleichstromkomponente des weiteren Signals (IF) als ein Maß für das Signal (Io) über einen Steueranschluss (CNTRL) als eine Gleichspannung über dem Widerstand (R) bereitgestellt wird.

7. Mobiltelephon, das einen Sender umfasst, der eine Antenne zum Senden eines modulierten Hochfrequenzsignals aufweist, einen Verstärker des Typs nach irgendeinem der Ansprüche 1 bis 4 umfassend, wobei die Last (ZL) von der Antenne gebildet wird.

## Revendications

1. Amplificateur pour fournir un signal (Io) à une charge (ZL) comprenant :
- un premier transistor (T1) ayant une première borne principale raccordée à une borne de référence (GND), une borne de commande et une deuxième borne principale pour fournir le signal (Io) à la charge (ZL),
- des moyens de détection pour déterminer une valeur du signal (Io), dans lequel les moyens de mesure comprennent un deuxième transistor (T2) ayant une première borne principale raccordée à la première borne principale du premier transistor (T1), une borne de commande raccordée à la borne de commande du premier transistor (T1), et une deuxième borne principale pour fournir un autre signal (IF), qui est une représentation du signal (Io), et
- des moyens de redressement (DMNS) pour fournir une composante continue de l'autre signal (IF), dans lequel l'autre signal est une représentation du signal (Io) et la composante continue de l'autre signal (IF) est générée en tant que mesure de la puissance fournie par le signal (Io) à la charge (ZL).

2. Amplificateur selon la revendication 1, dans lequel les moyens de détection (DMNS) comprennent une résistance (R) raccordée entre une borne d'alimentation (VDD) et la deuxième borne principale du deuxième transistor (T2), et un condensateur (C) raccordé à la deuxième borne principale du deuxième transistor (T2), et
dans lequel le condensateur (C) est configuré de manière à former un court-circuit pour les courants alternatifs de telle sorte que seule la composante continue de l'autre signal (IF) s'écoule à travers la résistance (R), et dans lequel la composante continue de l'autre signal (IF) est générée en tant que mesure de la puissance fournie par le signal (Io) à la charge (ZL) par l'intermédiaire d'une borne de contrôle (CNTRL) raccordée à la deuxième borne principale du deuxième transistor (T2).

3. Amplificateur selon la revendication 2, dans lequel le condensateur (C) est raccordé entre la deuxième borne principale du deuxième transistor (T2) et la borne de référence (GND).

4. Amplificateur selon la revendication 2, dans lequel le condensateur (C) est raccordé entre la deuxième borne principale du deuxième transistor (T2) et la borne d'alimentation (VDD).

5. Amplificateur selon l'une des revendications précédentes, dans lequel les premier et deuxième transistors (T1, T2) sont dimensionnés de telle sorte que l'autre signal (IF) qui s'écoule à travers le premier transistor (T1) est une fraction du signal (Io) qui s'écoule à travers le premier transistor (T1) et à travers la charge (ZL).

6. Amplificateur selon l'une des revendications précédentes 2 à 5, dans lequel la composante continue de l'autre signal (IF) en tant que mesure du signal (Io) est générée par l'intermédiaire d'une borne de contrôle (CNTRL) en tant que tension continue aux bornes de la résistance (R).

7. Téléphone mobile comprenant un émetteur ayant une antenne pour transmettre un signal haute fréquence modulé, comprenant un amplificateur du type correspondant à l'une des revendications 1 à 4, dans lequel la charge (ZL) est formée par l'antenne.
